# EUROPEAN PATENT SPECIFICATION

(11) **EP 3 623 496 B1**
(45) Date of publication and mention of the grant of the patent: **31.08.2022**
(21) Application number: 18798862.1
(22) Date of filing: 18.04.2018
(51) Int. Cl.: C23C 14/34, C23C 14/00, C23C 14/40, H01L 21/31, H01L 21/316, H01L 41/316, C23C 14/08, C23C 14/35, H01J 37/34

(54) **FILM FORMING DEVICE AND METHOD FOR FORMING PIEZOELECTRIC FILM**
FILMBILDENDE VORRICHTUNG UND VERFAHREN ZUR BILDUNG EINES PIEZOELEKTRISCHEN FILMS
DISPOSITIF DE FORMATION DE FILM ET PROCÉDÉ DE FORMATION DE FILM PIÉZOÉLECTRIQUE

(30) Priority: 09.05.2017 JP 2017092959
(43) Date of publication of application: 18.03.2020
(73) Proprietor: FUJIFILM Corporation, Tokyo 106-8620 (JP)
(72) Inventor: MURAKAMI, Naoki, Ashigarakami-gun Kanagawa 258-8577 (JP); TAKAHASHI, Shuji, Ashigarakami-gun Kanagawa 258-8577 (JP)
(74) Representative: Klunker IP Patentanwälte PartG mbB
(86) International application number: PCT/JP2018/016051
(87) International publication number: WO 2018/207577

(56) References cited:
- WO-A1-2016/136255
- JP-A- 2000 133 412
- JP-A- 2000 133 412
- JP-A- 2002 217 168
- JP-A- 2003 277 909
- JP-A- 2008 538 852
- JP-A- 2009 249 713
- JP-A- 2011 068 918
- JP-A- 2016 534 225
- US-A1- 2010 206 718
- US-A1- 2013 001 076

## Description

### BACKGROUND OF THE INVENTION

### 1. Field of the Invention

The present invention relates to a film forming device according to the preamble of claim 1 for forming a thin film using a sputtering method. It also relates to a method of forming a piezoelectric film using the film forming device.

### 2. Description of the Related Art

A method of forming a film using a sputtering method is well known as a technique of forming a thin film. In a sputtering device, plasma is generated in a film formation chamber, and a target disposed in the film formation chamber is sputtered such that a target material is deposited on a surface of a substrate disposed to face the target. As a result, a thin film can be formed. In the sputtering device, in order to prevent the target material from adhering to an inner wall surface of the film formation chamber during sputtering, an adhesion preventing plate is provided in the film formation chamber (for example, JP1994-200369A (JP-H6-200369A) or JP2003-247058A).

The present applicant discloses a method of forming a piezoelectric film having high piezoelectricity by sputtering (for example, JP2009-249713A).

A film forming device according to the preamble of claim 1 is known from US 2013/001076 A1. The inventors of the present invention have found that the formation of particles in a film forming step may occur not only during film formation (arching or the like) but also after the end of film formation. After the end of film formation, plasma is turned off, and thus a rapid potential change occurs in the chamber. Such situation may result in an impulsive force generating a strong force due to which deposits are spaced from the adhesion preventing plate surface to form particles.

US 2010/206718 A1 discloses also a film forming device similar to the preamble of claim 1 but does specify the gap between the adhesion prevention plates.

### SUMMARY OF THE INVENTION

As described above, during film formation in the film forming device, the target material adheres to the adhesion preventing plate. In a case where film formation is repeatedly performed, the amount of the target material adhered gradually increase. In a case where arcing occurs in the film formation chamber in a state where the target material adheres to the adhesion preventing plate, deposits adhering to the adhesion preventing plate are scattered to form particles, and there is a problem in that the particles adhere to a deposition surface. In addition, in a case where arcing occurs, a change in potential occurs on a substrate surface, which leads to a decrease in the performance of the formed thin film (for example, a decrease in thickness or a variation in composition).

In a case where a target to be formed is a piezoelectric film, due to the occurrence of arcing, there is a significant problem caused by deterioration in piezoelectric performance, for example, the formation of a region having no piezoelectricity in a pyrochlore layer or the like.

In addition, particles cause a decrease in yield, for example, due to wiring short-circuiting or dielectric breakdown of a piezoelectric film during device manufacturing. In addition, in a case where particles are present in a device, deterioration in durability or deterioration in resistance to driving at high temperature occurs. In order to form a piezoelectric film with high yield, it is necessary to suppress a decrease in yield or a decrease in in-plane distribution of thickness or film performance in a substrate surface caused by the occurrence of arcing. That is, as a film forming method, a method of forming a piezoelectric film having uniform thickness and film performance is required.

The present invention has been made in consideration of the above-described circumstances, and an object thereof is to provide a film forming device that can suppress the occurrence of arcing. In addition, another object of the present invention is to provide a method of forming a piezoelectric film having uniform thickness and film performance.

According to the present invention, there is provided a film forming device having the features of claim 1.

It is preferable that the film forming device according to the present invention further comprises: an abnormal discharge detecting portion that detects the occurrence of abnormal discharge in the film formation chamber; and an abnormal discharge controller that suppresses abnormal discharge in a case where the occurrence of abnormal discharge is detected by the abnormal discharge detecting portion.

In the film forming device according to the present invention, it is preferable that the abnormal discharge controller controls a plasma impedance.

The film forming device according to the present invention may further comprise an impedance matching box that is connected to the radio frequency sputtering power supply, in which the abnormal discharge controller may control the plasma impedance by controlling the impedance matching box such that a discharge frequency is adjusted.

In the film forming device according to the present invention, the abnormal discharge controller may control the plasma impedance by controlling the adjustment of the potential using the potential adjusting mechanism.

According to the present invention, there is provided a method of forming a piezoelectric film using the film forming device according to the present invention, the method comprising the features of claim 6.

In a case where the radio frequency sputtering power supply is turned off, the plasma density may be decreased stepwise by decreasing an output of the radio frequency sputtering power supply stepwise.

Alternatively, in a case where the radio frequency sputtering power supply is turned off, the plasma density may be decreased stepwise by pulse-driving an output of the radio frequency sputtering power supply and decreasing a pulse frequency stepwise.

Further, in a case where the radio frequency sputtering power supply is turned off, the plasma density may be decreased stepwise by adjusting a potential of the adhesion preventing plate connected to the potential adjusting mechanism using the potential adjusting mechanism while decreasing the plasma density stepwise.

In the film forming device according to the present invention, an adhesion preventing mechanism that prevents a target material in a film formation chamber from adhering to an inner wall surface of the film formation chamber is provided in the film forming chamber, the adhesion preventing mechanism is configured with a plurality of adhesion preventing plates including at least a substrate edge adhesion preventing plate that is provided on an edge of a region on the substrate holding portion where the substrate is provided and a substrate outer peripheral region adhesion preventing plate that is disposed on an outer periphery of the substrate edge adhesion preventing plate to be spaced from the substrate edge adhesion preventing plate, a potential adjusting mechanism that is electrically connected to any one of the substrate edge adhesion preventing plate or the substrate outer peripheral region adhesion preventing plate and adjusts a potential of the adhesion preventing plate is provided, and the adhesion preventing plate connected to the potential adjusting mechanism and an adhesion preventing plate adjacent to the adhesion preventing plate connected to the potential adjusting mechanism among the plurality of adhesion preventing plate are disposed at an interval of 0.5 mm to 3.0 mm. Therefore, the occurrence of arcing can be suppressed. Since the occurrence of arcing can be suppressed, film formation can be performed with stable plasma, and the occurrence of particles in the film formation chamber can be suppressed. Accordingly, a thin film having uniform thickness and film performance can be obtained. In addition, since the potential adjusting mechanism is provided, the potential of the substrate or the potential in the vicinity of the substrate can be made to be close to the plasma potential during film formation, and reverse sputtering can be suppressed. In particular, in the case of a PZT (lead zirconate titanate) type piezoelectric film, deterioration in film performance caused by Pb deficiency can be suppressed.

### BRIEF DESCRIPTION OF THE DRAWINGS

Fig. 1 is a schematic diagram illustrating a schematic configuration of a film forming device according to a first embodiment.
Fig. 2 is an enlarged view illustrating a part of the film forming device according to the first embodiment.
Fig. 3 is a plan view illustrating a positional relationship between a substrate, a substrate edge adhesion preventing plate, and a substrate outer peripheral region adhesion preventing plate in the film forming device.
Fig. 4 is a schematic diagram illustrating a schematic configuration of a film forming device according to a second embodiment.
Fig. 5 is a schematic diagram illustrating a schematic configuration of a film forming device according to a third embodiment.
Fig. 6 is a circuit diagram illustrating a first potential adjusting mechanism.
Fig. 7 is a circuit diagram illustrating a second potential adjusting mechanism.
Fig. 8 is a circuit diagram illustrating a third potential adjusting mechanism.
Fig. 9 is a circuit diagram illustrating a fourth potential adjusting mechanism.
Fig. 10 is a schematic diagram illustrating a schematic configuration of a film forming device according to a fourth embodiment.
Fig. 11 is a schematic diagram illustrating a schematic configuration of a film forming device according to a fifth embodiment.
Fig. 12A is a diagram illustrating one example of a change in potential during the occurrence of arcing.
Fig. 12B is a diagram illustrating another example of a change in potential during the occurrence of arcing.
Fig. 12C is a diagram illustrating still another example of a change in potential during the occurrence of arcing.
Fig. 13A is a diagram illustrating one example of a RF output (output of a radio frequency sputtering power supply) control during power-off.
Fig. 13B is a diagram illustrating another example of the RF output control during power-off.
Fig. 13C is a diagram illustrating still another example of the RF output control during power-off.

### DESCRIPTION OF THE PREFERRED EMBODIMENTS

Hereinafter, an embodiment of a piezoelectric film forming device and a method of forming a piezoelectric film according to the present invention will be described with reference to the drawings.

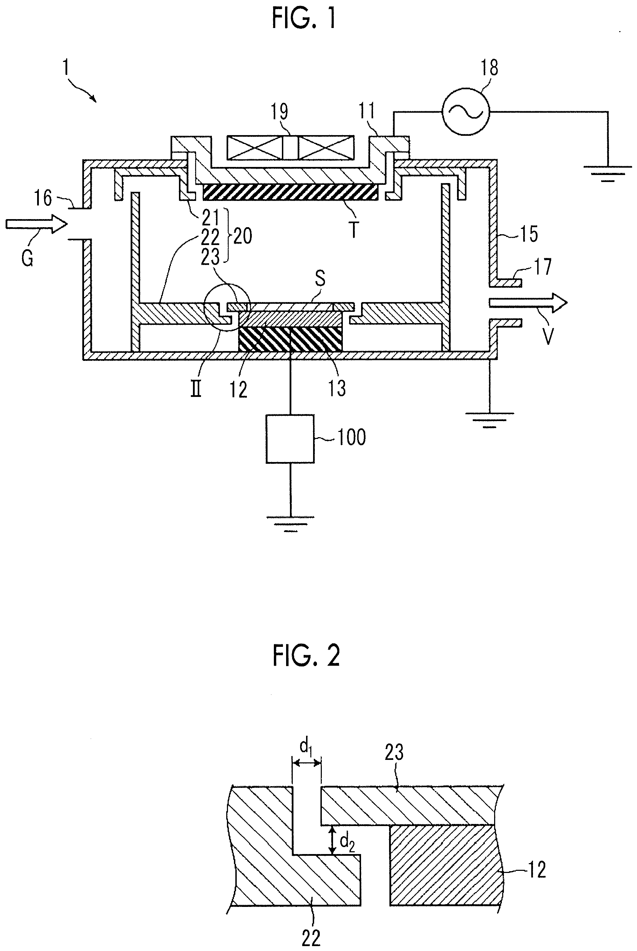

Fig. 1 illustrates a schematic configuration of a piezoelectric film forming device according to a first embodiment of the present invention.

The film forming device 1 is configured with a radio frequency sputtering device. The film forming device 1 includes: a film formation chamber 15 that is capable of introducing or discharging film forming gas G; a backing plate 11 as a target holding portion that is disposed in the film formation chamber 15 (hereinafter, also simply referred to as "chamber 15") and holds a target T; a stage 12 as a substrate holding portion that is disposed to face the backing plate 11 in the film formation chamber 15 and holds a substrate S; and a radio frequency sputtering power supply 18 (hereinafter, referred to as "RF sputtering power supply 18") that generates plasma in a space (film forming space) between the backing plate 11 functioning as a cathode and the stage 12.

The stage 12 has a configuration capable of heating the substrate S to a predetermined temperature and is fixed to a support 13 fixed to an inner wall surface of the film formation chamber 15. At least a part of the support 13 is formed of an insulator, and the stage 12 and the film formation chamber 15 are electrically spaced from each other by the support 13.

The backing plate 11 is connected to the RF sputtering power supply 18 disposed outside the chamber 15 and also functions as a plasma electrode (cathode electrode) for generating plasma. In order to improve the use efficiency of the target T, to increase the film formation rate, and to make the thickness uniform, a magnetron magnet 19 is disposed outside the backing plate 11.

In the film forming device 1, the RF sputtering power supply 18 and the backing plate 11 functioning as the plasma electrode (cathode electrode) configure plasma generation means for generating plasma in the chamber 15.

The film forming device 1 includes: gas introduction means 16 for introducing the film forming gas G into the chamber 15; and a gas discharge pipe 17 that discharges V gas in the chamber 15. As the film forming gas, for example, Ar or Ar/O₂ mixed gas is used.

Further, the film forming device 1 further comprises an adhesion preventing mechanism 20 that prevents a target material from adhering to an inner wall surface of the film formation chamber, the target material being sputtered and scattered from the target in the chamber 15. The adhesion preventing mechanism 20 is configured with a plurality of adhesion preventing plates and is disposed surrounding a film forming space to separate between the film forming space and the inner wall surface of the chamber 15. In the film forming device 1, the adhesion preventing mechanism 20 includes a target outer peripheral region adhesion preventing plate 21, a substrate edge adhesion preventing plate 23, and a substrate outer peripheral region adhesion preventing plate 22. The target outer peripheral region adhesion preventing plate 21 is fixed to the inner wall surface of the chamber 15 on the backing plate 11 side, surrounds the outer periphery of the target T mounted on the backing plate 11, and is provided to be spaced from the target T. The substrate edge adhesion preventing plate 23 is provided on an edge of a region on the stage 12 where the substrate S is provided. The substrate outer peripheral region adhesion preventing plate 22 is disposed on an outer periphery of the substrate edge adhesion preventing plate 23 to be spaced from the substrate edge adhesion preventing plate 23.

The film forming device 1 includes a potential adjusting mechanism 100 that is electrically connected to the substrate edge adhesion preventing plate 23 and adjusts a potential of the substrate edge adhesion preventing plate 23. The potential adjusting mechanism 100 is connected to the stage 12 and is electrically connected to the substrate edge adhesion preventing plate 23 through the stage 12.

The potential adjusting mechanism 100 can be configured with, for example, a high frequency power supply and an impedance matching box or the like for adjusting an impedance between the high frequency power supply and the stage 12. In addition, the potential adjusting mechanism 100 may include an LCR (L: inductance, C: capacitance: R: resistance) circuit in which an impedance for adjusting the potential of the stage 12 is variable such that the potential can be changed by changing the impedance of the stage 12.

In this example, as illustrated in Fig. 2, the substrate edge adhesion preventing plate 23 and the substrate outer peripheral region adhesion preventing plate 22 are disposed to be spaced from each other at a distance d₁ in a horizontal axis direction of the drawing and at a direction d₂ in a vertical axis direction perpendicular to the horizontal axis direction. Here, the adhesion preventing plates 22 and 23 are disposed such that the distances d₁ and d₂ are 0.5 mm to 3.0 mm. The distances d₁ and d₂ are preferably 1.0 mm or more, more preferably 1.5 mm or more, and still more preferably 2.0 mm or more. In addition, the distance (interval) between positions facing the substrate edge adhesion preventing plate 23 and the substrate outer peripheral region adhesion preventing plate 22 is 3.0 mm or less, preferably less than 3.0 mm, and more preferably 2.5 mm or less over the entire region.

From the viewpoint of preventing the target material from adhering to the inner wall surface of the chamber 15, among the plurality of adhesion preventing plates constituting the adhesion preventing mechanism 20 including the substrate edge adhesion preventing plate 23 and the substrate outer peripheral region adhesion preventing plate 22, the interval between adhesion preventing plates adjacent to each other is less than 3.0 mm and preferably 2.5 mm or more over the entire region.

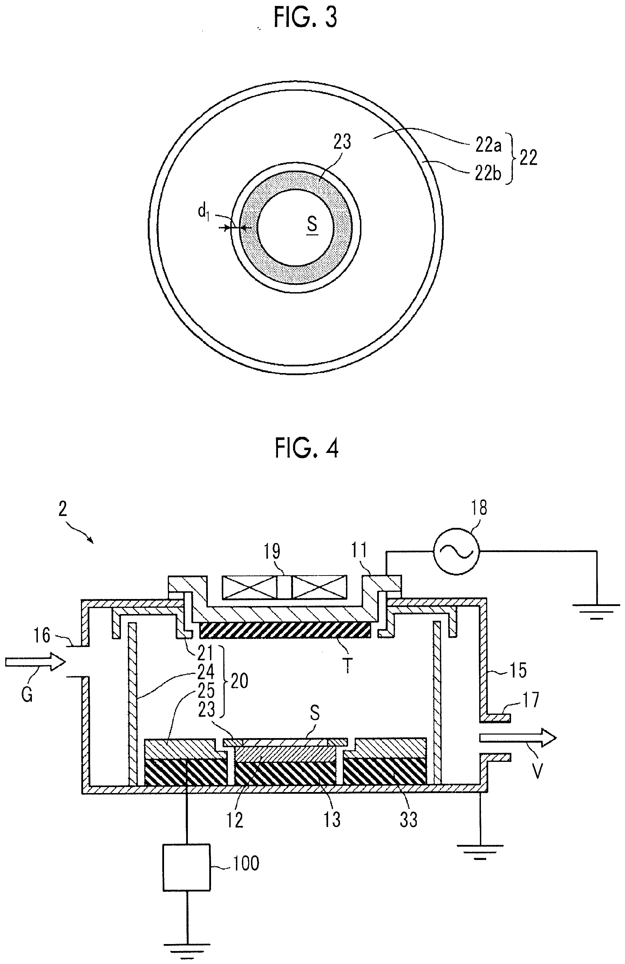

As illustrated in Fig. 3, the substrate edge adhesion preventing plate 23 indicated by grey in the drawing is a ring-shaped adhesion preventing plate surrounds the circular substrate S and hereinafter will be referred to as "adhesion preventing ring 23". The substrate outer peripheral region adhesion preventing plate 22 includes a ring surface portion 22a and a cylindrical portion 22b concentric with the adhesion preventing ring 23. In the substrate outer peripheral region adhesion preventing plate 22, a part of the cylindrical portion 22b is fixed to the inner wall surface of the chamber 15 (refer to Fig. 1).

The wall surface of the chamber 15 is set to ground (GND) potential, and the target outer peripheral region adhesion preventing plate 21 and the substrate outer peripheral region adhesion preventing plate 22 that are fixed and electrically connected to the inner wall surface of the chamber 15 are set to GND potential.

On the other hand, the adhesion preventing ring 23 is not connected to the chamber 15 and has a potential different from that of the substrate outer peripheral region adhesion preventing plate 22. The potential of the adhesion preventing ring 23 is set to be freely variable by the potential adjusting mechanism 100, and the substrate outer peripheral region adhesion preventing plate 22 is set to GND potential. Although the details will be described below, in a case where a piezoelectric film is formed, in order to make the potential of the stage 12 close to the plasma potential, a control is performed such that a predetermined potential difference from the GND potential is applied to the stage 12. Therefore, during film formation, a potential difference is generated between the adhesion preventing ring 23 and the substrate outer peripheral region adhesion preventing plate 22. At a position where a potential difference is present, arcing may occur. However, by setting the distance between the adhesion preventing ring 23 and the substrate outer peripheral region adhesion preventing plate 22 to be 0.5 mm or more, the occurrence of the arcing can be suppressed. By setting the distance between the adhesion preventing ring 23 and the substrate outer peripheral region adhesion preventing plate 22 to be 1.5 mm or more, the occurrence of arcing can be more effectively suppressed. By setting the distance between the adhesion preventing ring 23 and the substrate outer peripheral region adhesion preventing plate 22 to be 3.0 mm or less, the target material sputtered during film formation can be suppressed from entering into a gap between the adhesion preventing plates and adhering the side surface of the stage 12 or the inner wall surface of the chamber. The distance is more preferably 2.5 mm or less.

This way, by setting the distance between the adhesion preventing plates having a potential difference to be 0.5 mm or more, preferably 1.5 mm or more, and more preferably 2.0 mm or more, the occurrence of arcing can be suppressed.

In a case where a thin film to be formed is a piezoelectric film, the film performance of the piezoelectric film can be improved by setting the potential of the substrate to be close to the plasma potential (for example, about 40 to 50 V). Accordingly, in a case where a piezoelectric film is formed, it is preferable that a potential having a potential difference of 20 V or higher from the GND potential is applied to the stage 12 by the potential adjusting mechanism 100. In a case where the potential difference between the adhesion preventing ring 23 and the substrate outer peripheral region adhesion preventing plate 22 is 20 V or higher due to the potential adjustment, the distance therebetween for suppressing the occurrence of arcing is preferably 1.5 mm or more and more preferably 2.0 mm or more.

The substrate outer peripheral region adhesion preventing plate 22 may be set to a floating potential without being connected to the wall surface of the chamber 15. In a case where the substrate outer peripheral region adhesion preventing plate 22 is set to a floating potential, the adhesion preventing ring 23 or the target outer peripheral region adhesion preventing plate 21 have different potentials. In this case, it is preferable that not only the distance between the substrate outer peripheral region adhesion preventing plate 22 and the adhesion preventing ring 23 but also the distance between the substrate outer peripheral region adhesion preventing plate 22 and the target outer peripheral region adhesion preventing plate 21 satisfy a relationship of 0.5 mm to 3.0 mm. As in the above-described case, in a case where the distance is 0.5 mm or more, an effect of suppressing arcing that may occur at a position a potential difference is present can be obtained. In a case where the distance is 3.0 mm or less, the entrance of the material can be suppressed. That is, in a case where a potential difference is present between adhesion preventing plates disposed adjacent to each other, arcing may occur. Therefore, adhesion preventing plates adjacent to each other that have a potential difference are disposed at an interval of 0.5 mm or more, preferably 1.5 mm or more, and more preferably 2.0 mm or more.

It is preferable that a material of each of the adhesion preventing plates constituting the adhesion preventing mechanism 20 is nonmagnetic metal. SUS304 as stainless steel that is generally used has magnetism under a strong magnetic field during magnetron sputtering and generates a magnetic field between the adhesion preventing plates. Therefore, electrons are likely to transfer due to the magnetic field, and thus arcing is likely to occur. In a case where the material of the adhesion preventing plate is nonmagnetic metal, the adhesion preventing plate is not magnetized. Therefore, the occurrence of arcing is suppressed. From the viewpoint of excellent adhesiveness with the piezoelectric film, it is effective to use Ti among the nonmagnetic metals. However, since Ti is expensive, it is preferable to use relatively inexpensive stainless steel. It is effective to use SUS304L, SUS305, SUS305M, SUS316, or SUS316L that is likely to has magnetism among the stainless steels.

Fig. 4 is a schematic configuration of a film forming device 2 according to a second embodiment. The same components as those of the film forming device 1 according to the first embodiment will be represented by the same reference numerals, and the detailed description thereof will not be repeated. The same can be applied to the following embodiments.

In the film forming device 2 according to the embodiment, a part of the configuration of the adhesion preventing mechanism 20 is different from that of the film forming device 1. Instead of the substrate outer peripheral region adhesion preventing plate 22 including the ring surface portion and the cylindrical portion in the film forming device 1 according to the embodiment, the film forming device 2 according to the embodiment includes: a substrate outer peripheral region adhesion preventing plate 25 that includes a ring surface portion along an outer periphery of the adhesion preventing ring 23; and a cylindrical adhesion preventing plate 24 that is disposed on an outer periphery of the substrate outer peripheral region adhesion preventing plate 25.

In the film forming device 2, the substrate S is set to a floating potential. That is, the stage 12 that supports the substrate S and the adhesion preventing ring 23 that is provided on an outer edge of the substrate S are set to a floating potential. On the other hand, the potential adjusting mechanism 100 is connected to the substrate outer peripheral region adhesion preventing plate 25 such that the potential of the substrate outer peripheral region adhesion preventing plate 25 can be adjusted. The cylindrical adhesion preventing plate 24 is connected to the chamber 15 and is set to GND potential.

That is, in the film forming device 2, the target outer peripheral region adhesion preventing plate 21 and the cylindrical adhesion preventing plate 24 have GND potential, the substrate outer peripheral region adhesion preventing plate 25 has an adjusted potential, and the adhesion preventing ring 23 has a floating potential. As described above, in a case where a potential difference is present between adhesion preventing plate adjacent to each other during film formation, arcing is likely to occur. Accordingly, in the film forming device 2, the distance between the cylindrical adhesion preventing plate 24 and the substrate outer peripheral region adhesion preventing plate 25 adjacent to each other and the distance between the substrate outer peripheral region adhesion preventing plate 25 and the adhesion preventing ring 23 are 0.5 mm or more, preferably 1.0 mm or more, more preferably 1.5 mm or more, and still more preferably 2.0 mm or more. As a result, the occurrence of arcing between the respective adhesion preventing plates can be suppressed, and a high-quality piezoelectric film can be formed.

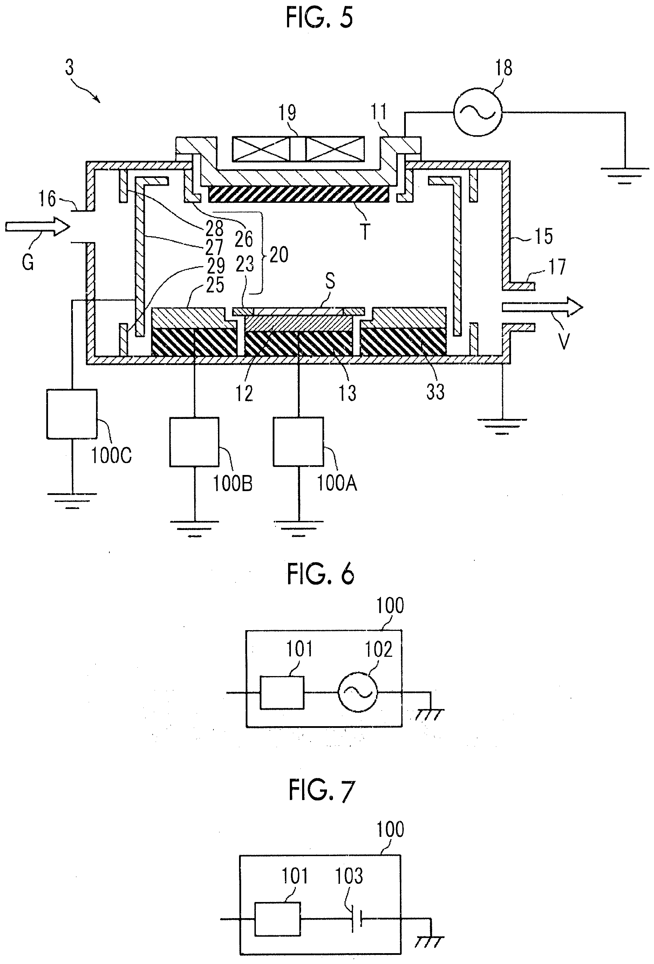

Fig. 5 is a schematic configuration illustrating a film forming device 3 according to a third embodiment.

In the film forming device 3 according to the embodiment, the adhesion preventing mechanism 20 includes six adhesion preventing plates 23 and 25 to 29. The adhesion preventing ring 23 and the substrate outer peripheral region adhesion preventing plate 25 that includes a ring surface portion along an outer periphery of the adhesion preventing ring 23 are the same as those of the film forming device 2. Further, the four cylindrical adhesion preventing plates 26, 27, 28, and 29 are disposed to surround the film forming space in cooperation with each other.

In the film forming device 3 according to the embodiment, a first potential adjusting mechanism 100A is connected to the adhesion preventing ring 23 through the stage 12 of the substrate S, a second potential adjusting mechanism 100B is connected to the substrate outer peripheral region adhesion preventing plate 25, and a third potential adjusting mechanism 100C is connected to the largest cylindrical adhesion preventing plate 27. The potential of each of the first potential adjusting mechanism 100A, the second potential adjusting mechanism 100B, and the third potential adjusting mechanism 100C can be adjusted. The other three cylindrical adhesion preventing plates 26, 28, and 29 are fixed to the inner wall surface of the chamber 15 and are electrically connected to the chamber to have GND potential.

This way, in the film forming device according to the embodiment the present invention, the number of adhesion preventing plates constituting the adhesion preventing mechanism 20, and the potential adjusting mechanism that adjusts a potential may be provided for each of the adhesion preventing plates, for one of the adhesion preventing plates, or for the plurality of adhesion preventing plates. The interval between adhesion preventing plates between which a potential difference is present during film formation may be 0.5 mm or more. In addition, from the viewpoint of preventing the entrance of the target material, the interval between adhesion preventing plate adjacent to each other is preferably less than 3.0 mm and more preferably 2.5 mm or more.

Even with this configuration, the effect of suppressing the occurrence of arcing between the adhesion preventing plates is exhibited. In addition, since the potential adjusting mechanism that adjusts a potential is provided for the plurality of adhesion preventing plates, a potential distribution suitable for more uniform film formation can be set.

Specific configuration examples of the potential adjusting mechanism 100 according to each of the embodiments are illustrated in Figs. 6 to 9.

The potential adjusting mechanism 100 illustrated in Fig. 6 includes an impedance matching box 101 and a high frequency power supply 102, and the high frequency power supply 102 is connected to the stage 12 or the adhesion preventing plate through the impedance matching box 101.

The potential adjusting mechanism 100 illustrated in Fig. 7 includes the impedance matching box 101 and a DC power supply 103, and the DC power supply 103 is connected to the stage or the adhesion preventing plate through the impedance matching box 101.

The potential of the stage or the adhesion preventing plate can be adjusted by the potential adjusting mechanism illustrated in Figs. 6 or 7.

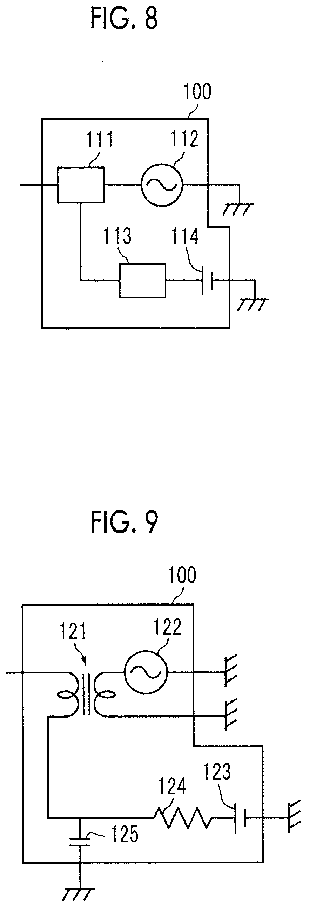

On the other hand, in a case where the potential adjusting mechanism is formed of a circuit in which the impedance matching box is used in a typical high frequency power supply, the adjusted potential may be a negative potential. In order to reduce a difference between the plasma potential and the potential in the vicinity of the substrate to suppress reverse sputtering, it is necessary that the adjusted potential is a positive potential. In order to make the adjusted potential a positive potential, the potential adjusting mechanism 100 having a configuration illustrated in Fig. 8 in which a DC power supply 114 is connected to a circuit in which an impedance matching box 111 is used in a typical high frequency power supply 112 through a high pass filter 113 may be used. In the potential adjusting mechanism 100 illustrated in Fig. 8, the potential can be adjusted to be positive.

In addition, the potential adjusting mechanism 100 having a transformer coupling circuit configuration illustrated in Fig. 9 in which a DC power supply 123 is connected to a circuit through a capacitor 125 and a resistor 124 may be used, the circuit including a transformer core 121 connected to a high frequency power supply 122. In the potential adjusting mechanism 100 illustrated in Fig. 9, the potential can be adjusted to be positive.

The film forming device according to the embodiment of the present invention may further include an abnormal discharge detecting portion and an abnormal discharge controller.

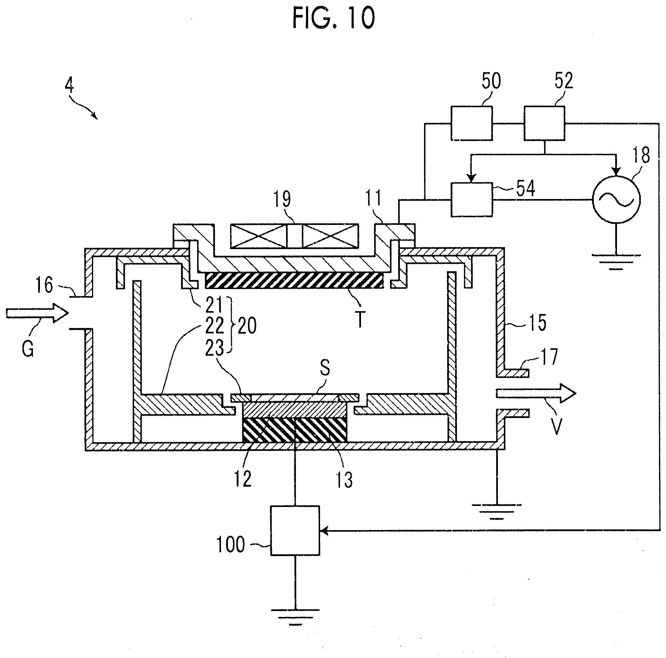

Fig. 10 illustrates a schematic configuration of a film forming device 4 according to a fourth embodiment.

In addition to the film forming device 1 according to the first embodiment illustrated in Fig. 1, the film forming device 4 may further include: an abnormal discharge detecting portion 50 that is connected to the RF sputtering power supply 18; an abnormal discharge controller 52 that is connected to the abnormal discharge detecting portion 50; and an impedance matching box 54 that is provided between the RF sputtering power supply 18 and the backing plate 11.

In a case where arcing occurs during film formation, a value of Vpp or Vdc in the RF sputtering power supply 18 changes. The abnormal discharge detecting portion 50 monitors Vpp or Vdc to check abnormal discharge based on a change in Vpp or Vdc. In a case where abnormal discharge is detected, the abnormal discharge controller 52 connected to the RF sputtering power supply 18, the impedance matching box 54, and the potential adjusting mechanism 100 transmits a signal for controlling the plasma impedance to the RF sputtering power supply 18, the impedance matching box 54, and/or the potential adjusting mechanism 100 to operate the RF sputtering power supply 18, the impedance matching box 54, and/or the potential adjusting mechanism 100 such that abnormal discharge can be suppressed.

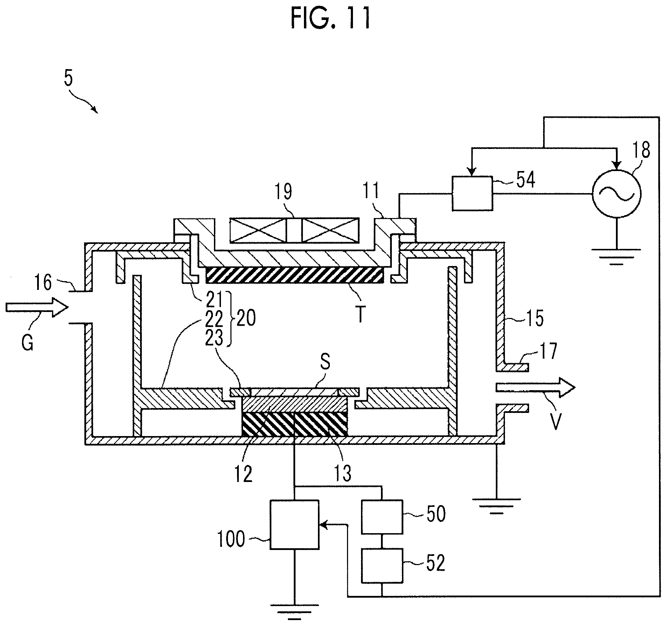

Fig. 11 is a schematic diagram illustrating a schematic configuration of a film forming device 5 according to a fifth embodiment.

In addition to the film forming device 1 according to the first embodiment illustrated in Fig. 1, the film forming device 5 may further include: the abnormal discharge detecting portion 50 that is connected to the potential adjusting mechanism 100; the abnormal discharge controller 52 that is connected to the abnormal discharge detecting portion 50; and the impedance matching box 54 that is provided between the RF sputtering power supply 18 and the backing plate 11. In a case where abnormal discharge occurs during film formation, a value of Vpp or Vdc in the RF sputtering power supply 18 changes. In a case where Vpp or Vdc of the RF sputtering power supply 18 changes, the potential of the stage 12 or the adhesion preventing plate 23 of which the potential is adjusted by the potential adjusting mechanism 100 also changes. In the device 5, the abnormal discharge detecting portion 50 monitors the potential of the stage 12 to check abnormal discharge based on a change in the potential of the stage 12. In a case where abnormal discharge is detected, the abnormal discharge controller 52 connected to the potential adjusting mechanism 100, the RF sputtering power supply 18, and the impedance matching box 54 transmits a signal for controlling the plasma impedance to the potential adjusting mechanism 100, the RF sputtering power supply 18, and/or the impedance matching box 54 to operate the potential adjusting mechanism 100, the RF sputtering power supply 18, and/or the impedance matching box 54 such that abnormal discharge can be suppressed.

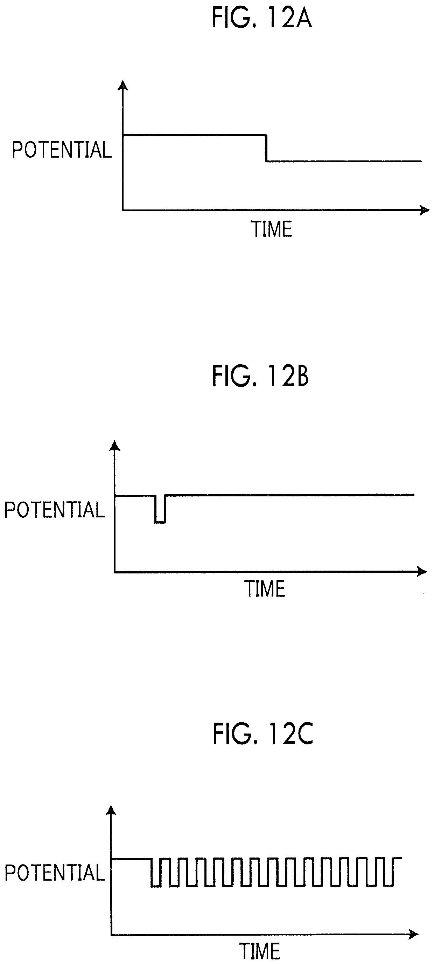

Examples of a change in the potential of the stage detected by the abnormal discharge detecting portion 50 in the film forming device 5 illustrated in Fig. 11 during abnormal discharge are schematically illustrated in Figs. 12A to 12C. During regular discharge, the potential is constant, but the voltage fluctuates during the occurrence of abnormal discharge. As illustrated in Fig. 12A, abnormal discharge occurs, and the potential decreases from the initial potential. As illustrated in Fig. 12B, the potential temporarily decreases during abnormal discharge and then may return to the initial potential immediately. Further, as illustrated in Fig. 12C, the potential periodically changes from the time of occurrence of abnormal discharge, and abnormal discharge may occur intermittently.

By controlling the plasma impedance when the initial abnormal discharge is detected, the continuation of abnormal discharge can be suppressed or the further occurrence of abnormal discharge can be suppressed. During the control of abnormal discharge, the plasma impedance is controlled such that the plasma potential decreases. For the control of the plasma impedance, for example, the following can be performed.

The plasma impedance can be controlled by changing the impedance of the impedance matching box 54 on the cathode side, and the abnormal discharge can be suppressed by decreasing the plasma potential.

In addition, the plasma impedance can be controlled by finely adjusting an output of the RF sputtering power supply 18, and the abnormal discharge can be suppressed by decreasing the plasma potential. For example, in a case where the output of the RF sputtering power supply during film formation is 2.0 kW, for the fine adjustment of the output, the output is decreased to 1.5 kW for about 1 second and then is made to return to the initial output.

Alternatively, the plasma impedance can be controlled by finely adjusting an radiation frequency of the RF sputtering power supply 18, and the abnormal discharge can be suppressed by decreasing the plasma potential. During the fine adjustment of the radiation frequency, for example, the frequency that is typically output as 13.56 MHZ is changed per several Hz.

The control of the plasma impedance using the potential adjusting mechanism 100 can be implemented by changing the output of the power supply in the potential adjusting mechanism 100 or by changing the impedance of the LCR circuit to change the potential. Accordingly, abnormal discharge can be suppressed by the potential adjusting mechanism 100. For example, abnormal discharge may be suppressed by temporarily setting the potential of the stage 12 to be low, and in a case where abnormal discharge disappears, the potential of the stage 12 may be made to return to the initial value.

### <Method of Forming Piezoelectric Film>

An embodiment of a method of forming a piezoelectric film using the film forming device according to the embodiment of the present invention will be described.

The kind of the piezoelectric film that is formed using the film forming device according to the embodiment of the present invention is not particularly limited. Examples of the piezoelectric film include a piezoelectric film including a perovskite type oxide represented by Formula ABO₃.

In particular, in a case where A (hereinafter, also referred to as "A site" in the formula) includes at least Pb, the effect obtained by using the film forming device according to the embodiment of the present invention is high. During sputtering, Pb is likely to be reversely sputtered, and deficiency is likely to occur. By using the film forming device according to the embodiment of the present invention, Pb deficiency can be effectively suppressed.

In addition, the method of forming a piezoelectric film using the film forming device according to the embodiment of the present invention is particularly suitable for a so-called PZT (lead zirconate titanate) type piezoelectric film in which B (hereinafter, also referred to as "B site") in Formula P includes at least Zr and Ti.

Hereinafter, a method of forming a piezoelectric film using the film forming device 1 according to the first embodiment will be described.

In a case where a piezoelectric film formed of PZT is formed, for example, film forming conditions are as follows.

As the target T, PZT is used. The compositional ratio is selected depending on a desired piezoelectric film.

The substrate S is not particularly limited and can be appropriately selected depending on the use, for example, a Si substrate, an oxide substrate, a glass substrate, or various flexible substrates. In a case where a piezoelectric element is manufactured, the various substrates having a surface on which an electrode layer is provided may be used.

As the film forming gas, mixed gas obtained by adding oxygen gas to argon is preferably used. The addition amount of oxygen gas may be 0.1% to 10% with respect to 10 to 100 sccm of argon gas. For example, the amount of argon gas may be 50 sccm, and the amount of oxygen gas may be 5 sccm. The vacuum degree in the chamber 15 may be 0.1 to 1.0 Pa, for example, 0.5 Pa. The output of the RF sputtering power supply 18 for generating plasma may be 1 to 5 kW, for example, 2 kW. The substrate temperature may be 400°C to 700°C, for example, 500°C.

Sputtering starts by turning on the RF sputtering power supply 18 to generate plasma in the chamber 15. Using the potential adjusting mechanism 100, sputtering is performed in a state where a potential of 20 V or higher is applied to the stage 12 and the adhesion preventing ring 23.

The stage 12 and the adhesion preventing ring 23 are set to a potential of 20 V or higher by the potential adjusting mechanism 100. Therefore, the potential can be made to be close to the plasma potential as compared to a case where the substrate S is set to GND potential. By reducing a potential difference from the plasma potential, the collision energy of ions with the substrate S can be reduced. In a case where a difference between the potential of the substrate and the plasma potential is large, reverse sputtering increases, and there is a problem in that, for example, the film formation rate decreases or crystal defects occur such that the piezoelectric performance of the piezoelectric film deteriorates. However, by controlling the potential of the substrate S to be close to the plasma potential, reverse sputtering to the substrate S can be suppressed, and a sufficient film formation rate can be secured. In addition, since reverse sputtering can be suppressed, Pb ions in the PZT type piezoelectric film can be arranged on the A site of the perovskite structure, and the amount of Pb ions that are unstable in crystals can be reduced. As a result, Pb deficiency can be suppressed, and thus a piezoelectric film having high piezoelectric performance can be formed.

This way, in a case where the film forming device 1 is used, by applying a potential of 20 V or higher to the stage 12, the potential of the substrate S and the adhesion preventing ring 23 provided on the edge of the substrate S can be increased to be close to the plasma potential. By setting the stage 12 to a floating potential as in the film forming device 2, the potential is close to the peripheral plasma potential or the peripheral potential such as the potential of the substrate outer peripheral region adhesion preventing plate 22 that is set to be 20 V or higher by the potential adjusting mechanism 100. As a result, the substrate S can be set to a potential close to the plasma potential.

After a predetermined thickness (a desired thickness that is freely determined) is reached by performing film formation as described above, the RF sputtering power supply 18 is turned off to stop film formation. Here, in a case where the RF sputtering power supply is turned off, it is preferable to decrease the plasma density stepwise.

According to an investigation by the present inventors, the formation of particles in a piezoelectric film forming step may occur not only during film formation (arcing or the like) but also after the end of film formation. After the end of film formation, plasma is turned off, and thus a rapid potential change occurs in the chamber 15. In a state where the piezoelectric film is deposited on the adhesion preventing plate, electric field stress caused by a sheath electric field on the adhesion preventing plate surface (surfaces of deposits) acts on deposits as an impulsive force. Due to the action of a strong force that is instantaneously generated due to the impulsive force, the deposits are spaced from the adhesion preventing plate surface to form particles. The impulsive force generated by a rapid potential change can be suppressed by preventing a rapid potential change. That is, the plasma potential in the chamber 15 can be controlled by controlling the plasma density, and the plasma potential can be decreased stepwise by decreasing the plasma density stepwise.

The plasma density can be decreased by decreasing the output of the RF sputtering power supply. In this case, the output of the RF sputtering power supply may be decreased by controlling a combination of the gas flow rate and the vacuum degree.

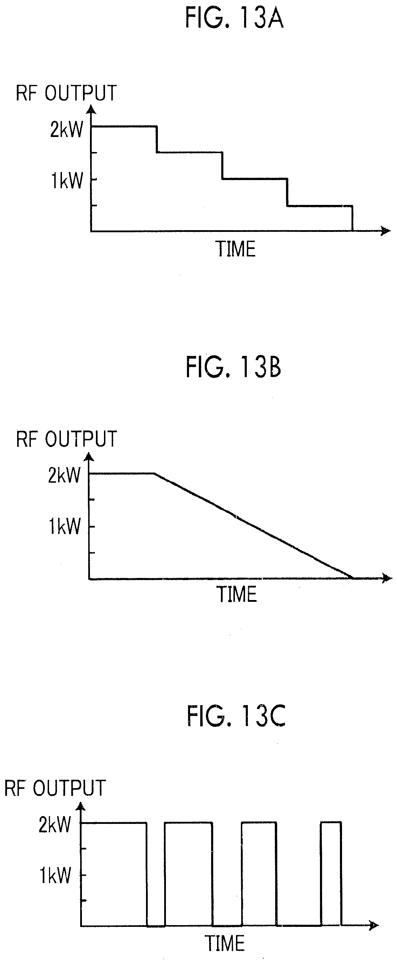

For example, in a case where the radio frequency output of the RF sputtering power supply is set to 2 kW for film formation, as schematically illustrated in Fig. 13A, the output of the RF sputtering power supply is decreased stepwise, for example, 2.0 kW→1.5 kW→1.0 kW→0.5 kW→0 kW. At this time, the output is decreased stepwise per 1 to 300 seconds.

In addition, as illustrated in Fig. 13B, the effect of suppressing the impulsive force can be further obtained by gradually decreasing the output of the RF sputtering power supply (continuously decreasing the output).

In addition, as a method of decreasing the output of the RF sputtering power supply, a method of decreasing the output by switching driving from continuous wave (CW) driving to pulse driving can be used. In addition, the output of the RF sputtering power supply can also be decreased stepwise using a method of decreasing the discharge frequency stepwise from an initial value, for example, 13.56 MHz or a method of decreasing the duty ratio from 100% in a state where the discharge frequency is fixed as illustrated in Fig. 13C. Examples of the method of decreasing the output by switching driving to pulse driving include a method of decreasing the pulse frequency by changing the ON/OFF time in a state where the duty ratio is set to 50%, a method of decreasing the duty ratio from 100% to 0% stepwise in a state where the pulse frequency is set to 100 kHz, and a method of decreasing both the frequency and the duty ratio stepwise. The time for which the duty ratio is decreased may be 60 to 180 sec.

In a case where the RF sputtering power supply is turned off, it is also effective to adjust the potential using the potential adjusting mechanism 100 provided in the adhesion preventing plate or the stage while decreasing the plasma density stepwise. For example, a rapid potential change can be suppressed by decreasing the output of the high frequency power supply or the DC power supply provided in the potential adjusting mechanism 100 stepwise or by adjusting the impedance of the LCR circuit while decreasing the plasma density.

This way, by decreasing the output of the RF sputtering power supply stepwise, the formation of particles can be suppressed as compared to a case where the power supply is abruptly turned off, and the number of particles adhering to the formed piezoelectric film can be reduced.

In a case where the output is decreased stepwise, as the time for which the output decreases increases, the potential change can be made more gentle. On the other hand, in a case where the time for which the output decreases is excessively long, the film quality may change. For example, the composition of the piezoelectric film changes. Therefore, it is preferable that the time is set to about 60 to 180 sec.

Hereinafter, the result of an experiment for verifying the effects of the film forming device according to the embodiment of the present invention during the piezoelectric film formation and the effects of the film forming method using the according to the film forming device according to the embodiment of the present invention will be described.

In the following verification experiment, a PZT film was formed using the film forming device 1 illustrated in Fig. 1.

PZT was used as the target T, and a Si substrate was used as the substrate. As the film forming gas, mixed gas including 50 sccm of argon gas and 5 sccm of oxygen gas was used. The vacuum degree in the chamber 15 was set to 0.5 Pa, and the output of the RF sputtering power supply 18 for generating plasma was set to 2 kW. In addition, the substrate temperature was set to 500°C.

### <Verification Experiment 1>

Using the film forming device 1 illustrated in Fig. 1, the PZT film was formed by changing the distance between the adhesion preventing ring 23 and the substrate outer peripheral region adhesion preventing plate 22 in a range of 0.5 mm to 3.0 mm and adjusting the potential difference from the GND potential of the stage 12, that is, the adhesion preventing ring 23 to 10 V, 20 V, or 30V using the potential adjusting mechanism 100 at each distance. The substrate outer peripheral region adhesion preventing plate 22 in the film forming device 1 illustrated in Fig. 1 is set to GND potential. Therefore, the potential difference between the substrate outer peripheral region adhesion preventing plate and the adhesion preventing ring 23 is 10 V, 20 V, or 30 V.

Whether or not abnormal discharge occurred during film formation was investigated under each of conditions. In addition, in a case where film formation was performed at each distance, whether or not the target material entered into the chamber inner wall surface was investigated. The results are shown in Table 1.

**[Table 1]**

| Distance between Adhesion Preventing Plates | Potential Difference | Abnormal Discharge | Film Entrance |
|---|---|---|---|
| 0.5 mm | 10V | Not Occurred | Not Occurred |
| | 20V | Occurred | |
| | 30V | Occurred | |
| 1.0 mm | 10V | Not Occurred | Not Occurred |
| | 20V | Not Occurred/Occurred | |
| | 30V | Occurred | |
| 1.5 mm | 10V | Not Occurred | Not Occurred |
| | 20V | Not Occurred | |
| | 30V | Not Occurred/Occurred | |
| 2.0 mm | 10V | Not Occurred | Not Occurred |
| | 20V | Not Occurred | |
| | 30V | Not Occurred | |
| 2.5 mm | 10V | Not Occurred | Not Occurred |
| | 20V | Not Occurred | |
| | 30V | Not Occurred | |
| 3.0 mm | 10V | Not Occurred | Occurred |
| | 20V | Not Occurred | |
| | 30V | Not Occurred | |

Even in a case where the distance between the adhesion preventing plates was 0.5 mm, abnormal discharge did not occur at a potential difference of 10 V. It was clarified that, in order to suppress abnormal discharge, it is effective to set the distance between the adhesion preventing plates to be 1.5 mm or more. In addition, it can be seen that, by reducing the potential difference, the effect of suppressing abnormal discharge can be obtained. By setting the distance between the adhesion preventing plates to be 2.0 mm or more, abnormal discharge did not occur even at a potential difference of 30 V. On the other hand, in a case where the distance between the adhesion preventing plates was 3.0 mm, deposits were present on the wall surface of the film formation chamber. Accordingly, it can be seen that the distance between the adhesion preventing plates is preferably less than 3.0 mm and more preferably 2.5 mm or less.

### <Verification Experiment 2>

In the film forming device 1 illustrated in Fig. 1, in a case where a potential difference between the potential of the stage 12 (that is, the substrate potential) and the GND potential was set to 10 V, 20 V, or 30 V using the potential adjusting mechanism 100, the film formation rate of the PZT piezoelectric film was investigated. The results are shown in Table 2.

**[Table 2]**

| Potential Difference | Film Formation Rate |
|---|---|
| 10 V | 40 nm/min |
| 20 V | 60 nm/min |
| 30 V | 70 nm/min |

In a case where the potential difference was 20 V or higher, the film formation rate was 60 nm/min, and sufficient productivity was obtained. In order to obtain excellent productivity, it is preferable that the potential difference is 20 V or higher.

### <Verification Experiment 3>

The results of comparing the number of particles between the method of decreasing the radio frequency output of the plasma generation portion stepwise after the end of film formation and the method of the related art are shown in Table 3.

In Comparative Example and Examples 1 to 6, all the steps of forming the PZT film were common, and only final steps of turning off the RF sputtering power supply were different from each other.

In Comparative Example, by turning off the RF sputtering power supply when the output during film formation was 2 kW, the output was decreased to 0 kW.

In Examples 1 to 3, as illustrated in Fig. 13A, the output was decreased from 2 kW to 0 kW stepwise by 0.5 kW. In Examples 1 to 3, the times for which the output decreased from 2 kW to 0 kW were different from each other.

In Example 4, as illustrated in Fig. 13B, the output was continuously decreased from 2 kW to 0 kW. At this time, the time for which the output decreased was 60 sec.

In Example 5, as illustrated in Fig. 13C, the duty ratio of the pulse frequency was changed.

In Example 6, as in Example 1, the power supply output of the potential adjusting mechanism was decreased stepwise while decreasing the output of the power supply stepwise.

Regarding the piezoelectric film prepared using the method according to each of Comparative Example and Examples 1 to 6, the number of particles adhering to the surface and the film quality were investigated.

The number of particles on the wafer surface was measured using a particle counter (SP1, manufactured by KLA Corporation).

The film quality was evaluated based on the film composition using an fluorescent X-ray spectrometer (Wafer X310, manufactured by Rigaku Corporation). A change in film quality was evaluated based on whether or not the proportion of each of the compositions was changed.

**[Table 3]**

| | Output Decrease Time (sec) | Number of Particles (Particle/Wafer) | Film Quality |
|---|---|---|---|
| Comparative Example | 0 | 105 | Standard |
| Example 1 (Stepwise) | 60 | 83 | No Change |
| Example 2 (Stepwise) | 120 | 80 | No Change |
| Example 3 (Stepwise) | 300 | 78 | Changed |
| Example 4 (Slope) | 60 | 76 | No Change |
| Example 5 (Pulse) | 60 | 81 | No Change |
| Example 6 (Complex) | 60 | 75 | No Change |

As shown in Table 3, the effect of reducing the number of particles by decreasing the output stepwise was able to be verified as compared to Comparative Example in which the RF sputtering power supply was abruptly turned off. As the time for which the output was decreased stepwise increased, the number of particles tended to be small. On the other hand, it was clarified that, as the time for which the output is decreased is long as in Example 3, the film quality changes.

In Example 6 in which the power supply output of the potential adjusting mechanism was decreased stepwise while decreasing the output of the sputtering power supply, the effect of reducing the number of particles was highest.

### Explanation of References

1, 2, 3, 4, 5: film forming device
11: backing plate (target holding portion)
12: stage (substrate holding portion)
13: support
15: film formation chamber
16: gas introduction means
17: gas discharge pipe
18: radio frequency sputtering power supply
19: magnetron magnet
20: adhesion preventing mechanism
21: target outer peripheral region adhesion preventing plate
22: substrate outer peripheral region adhesion preventing plate
22a: ring surface portion
22b: cylindrical portion
23: adhesion preventing ring (substrate edge adhesion preventing plate)
24, 25, 26, 27: adhesion preventing plate
50: abnormal discharge detecting portion
52: abnormal discharge controller
54: impedance matching box
100, 100A, 100B, 100C: potential adjusting mechanism
101: impedance matching box
102, 112, 122: high frequency power supply
103, 114, 123: DC power supply
111: impedance matching box
113: high pass filter
121: transformer core
124: resistor

## Claims

1. A film forming device (1, 2, 3, 4, 5) adapted to form a thin film on a substrate by sputtering a target, the film forming device comprising:
a film formation chamber (15) that is capable of introducing or discharging film forming gas;
a target holding portion (11) adapted to hold the target disposed in the film formation chamber (15) ;
a substrate holding portion (12) that is disposed to face the target holding portion (11) in the film formation chamber (15) and is adapted to hold a substrate;
a radio frequency sputtering power supply (18) adapted to generate plasma in a space between the target holding portion (11) and the substrate holding portion (12),
wherein an adhesion preventing mechanism (20) adapted to prevent a target material from adhering to an inner wall surface of the film formation chamber (15), the target material being sputtered and scattered from the target in the film formation chamber(15), wherein
the adhesion preventing mechanism (20) is configured with a plurality of adhesion preventing plates including at least a substrate edge adhesion preventing plate (23) that is provided on an edge of a region on the substrate holding portion (12) where the substrate is provided and a substrate outer peripheral region adhesion preventing plate (22) that is disposed on an outer periphery of the substrate edge adhesion preventing plate (23) to be spaced from the substrate edge adhesion preventing plate (23), and
a potential adjusting mechanism (100) that is electrically connected to any one of the substrate edge adhesion preventing plate (23) or the substrate outer peripheral region adhesion preventing plate (22) and is adapted to adjust a potential of the adhesion preventing plate (23), wherein
the adhesion preventing plate (23) connected to the potential adjusting mechanism (100) and an adhesion preventing plate adjacent to the adhesion preventing plate (23) connected to the potential adjusting mechanism (100) among the plurality of adhesion preventing plate are disposed at an interval of 0.5 mm to 3.0 mm, and
**characterized in that** the radio frequency sputtering power supply (18) and / or the potential adjusting mechanism (100) are configured to decrease the plasma density stepwise, in a case where the radio frequency sputtering power supply (18) is turned off after the piezoelectric film reaches a predetermined thickness.

2. The film forming device (1, 2, 3, 4, 5) according to claim 1, further comprising:
an abnormal discharge detecting portion (50) adapted to detect the occurrence of abnormal discharge in the film formation chamber (15); and
an abnormal discharge controller (52) adapted to suppress abnormal discharge in a case where the occurrence of abnormal discharge is detected by the abnormal discharge detecting portion (50).

3. The film forming device (1, 2, 3, 4, 5) according to claim 2,
wherein the abnormal discharge controller (52) is adapted to control a plasma impedance.

4. The film forming device (1, 2, 3, 4, 5) according to claim 3, further comprising:
an impedance matching box (54) that is connected to the radio frequency sputtering power supply (18),
wherein the abnormal discharge controller (52) is adapted to control the plasma impedance by controlling the impedance matching box (54) such that a discharge frequency is adjusted.

5. The film forming device (1, 2, 3, 4, 5) according to claim 3,
wherein the abnormal discharge controller (52) is adapted to control the plasma impedance by controlling the adjustment of the potential using the potential adjusting mechanism (100).

6. A method of forming a piezoelectric film using the film forming device (1, 2, 3, 4, 5) according to any one of claims 1 to 5, the method comprising:
starting sputtering by turning on the radio frequency sputtering power supply (18) to generate plasma; and
forming a piezoelectric film by depositing a target material on the substrate in a state where a potential having a potential difference of 20 V or higher from a ground potential is applied to the adhesion preventing plate (23) connected to the potential adjusting mechanism by the potential adjusting mechanism (100),
**characterized in that**
in a case where the radio frequency sputtering power supply (18) is turned off after the piezoelectric film reaches a predetermined thickness, a plasma density is decreased stepwise.

7. The method of forming a piezoelectric film according to claim 6,
wherein in a case where the radio frequency sputtering power supply (18) is turned off, the plasma density is decreased stepwise by decreasing an output of the radio frequency sputtering power supply (18) stepwise.

8. The method of forming a piezoelectric film according to claim 6,
wherein in a case where the radio frequency sputtering power supply (18) is turned off, the plasma density is decreased stepwise by pulse-driving an output of the radio frequency sputtering power supply (18) and decreasing a pulse frequency stepwise.

9. The method of forming a piezoelectric film according to any one of claims 6 to 8,
wherein in a case where the radio frequency sputtering power supply (18) is turned off, the plasma density is decreased stepwise by adjusting a potential of the adhesion preventing plate (23) connected to the potential adjusting mechanism using the potential adjusting mechanism (100) while decreasing the plasma density stepwise.

## Patentansprüche

1. Schichtbildungsvorrichtung (1, 2, 3, 4. 5), ausgebildet zum Bilden einer Dünnschicht auf einem Substrat durch Zerstäuben eines Targets, umfassend:
eine Schichtbildungskammer (15), die in der Lage ist, ein Schichtbildungsgas einzuleiten oder auszuleiten;
einen Targethalteabschnitt (11), ausgebildet zum Halten des in der Schichtbildungskammer (15) angeordneten Targets;
einen Substrathalteabschnitt (12), der sich gegenüber dem Targethalteabschnitt (11) innerhalb der Schichtbildungskammer (15) befindet und dazu ausgebildet ist. ein Substrat zu halten;
eine Hochfrequenz-Zerstäubungsenergiequelle (18), ausgebildet zum Erzeugen von Plasma in einem Raum zwischen dem Targethalteabschnitt (11) und dem Substrathalteabschnitt (12),
wobei ein Anhaft-Verhinderungsmechanismus (20) ausgebildet ist zum Verhindern, dass ein Targetmaterial an einer Innenwandfläche der Schichtbildungskammer (15) anhaftet, während das Targetmaterial von dem Target innerhalb der Schichtbildungskammer (15) zerstäubt und gestreut wird, wobei
der Anhaft-Verhinderungsmechanismus (20) konfiguriert ist mit einer Mehrzahl von Anhaft-Verhinderungsplatten einschließlich mindestens einer Substratkanten-Anhalt-Verhinderungsplatte (23), die an einem Rand einer Zone an dem Substrathalteabschnitt (12) dort vorgesehen ist, wo sich das Substrat befindet, und eine Substrataußenumfangsbereichs-Anhaft-Verhinderungsplatte (22), die sich an einer Außenperipherie der Substratkanten-Anhaft-Verhinderungsplatte (23) mit Abstand von der Substratkanten-Anhaft-Verhinderungsplatte (23) befindet, und
einen Potentialeinstellmechanismus (100), der elektrisch an irgendeine von der Substratkanten-Anhaft-Verhinderungsplatte (23) oder der Substrataußenumfangszonen-Anhaft-Verhinderungsplatte (22) angeschlossen und ausgebildet ist zum Einstellen eines Potentials der Anhaft-Verhinderungsplatte (23), wobei
die Anhaft-Verhinderungsplatte (23), die mit dem Potentialeinstellmechanismus (100) verbunden ist, und eine Anhaft-Verhinderungsplatte benachbart zu der mit dem Potentialeinstellmechanismus (100) verbundenen Anhaft-Verhinderungsplatte (23) von den mehreren Anhaft-Verhinderungsplatten in einem Intervall von 0,5 mm bis 3,0 mm angeordnet sind, und
**dadurch gekennzeichnet, dass** die Hochfrequenz-Zerstäubungsenergiequelle (18) und/oder der Potenlialeinstellmechanismus (100) konfiguriert sind zum stufenweisen Verringern der Plasmadichte dann, wenn die Hochfrequenz-Zerstäubungsenergiequelle (18) abgeschaltet ist, nachdem die piezoelektrische Schicht eine vorbestimmte Dicke erreicht hat.

2. Schichtbildungsvorrichtung (1, 2, 3, 4, 5) nach Anspruch 1, weiterhin umfassend:
einen Anormal-Entladungs-Detektorabschnitt (50), ausgebildet zum Nachweisen des Auftretens einer anormalen Entladung innerhalb der Schichtbildungskammer (15): und
eine Anormal-Entladungs-Steuerung (52), ausgebildet zum Unterdrücken einer anormalen Entladung dann, wenn das Auftreten einer anormalen Entladung von dem Anormal-Entladungs-Detektorabschnitt (50) nachgewiesen wird.

3. Schichtbildungsvorrichtung (1, 2. 3. 4, 5) nach Anspruch 2.
bei der die Anormal-Entladungs-Steuerung (52) ausgebildet ist zum Steuern einer Plasmaimpedanz.

4. Schichtbildungsvorrichtung (1, 2, 3, 4 5) nach Anspruch 3, weiterhin umfassend:
eine Impedanzanpassbox (54), die mit der Hochfrequenz-Zerstäubungsenergiequelle (18) verbunden ist,
wobei die Anormal-Entladungs-Steuerung (52) ausgebildet ist zum Steuern der Plasmaimpedanz durch Steuern der Impedanzanpassbox (50) derart, dass eine Entladungsfrequenz eingestellt wird.

5. Schichtbildungsvorrichtung (1, 2, 3, 4. 5) nach Anspruch 3,
bei der die Anormal-Entladungs-Steuerung (52) ausgebildet ist zum Steuern der Plasmaimpedanz durch Steuern der Einstellung des Potentials unter Verwendung des Potentialeinstellmechanismus' (100).

6. Verfahren zum Bilden einer piezoelektrischen Schicht unter Verwendung der Schichtbildungsvorrichtung (1, 2, 3, 4, 5) nach einem der Ansprüche 1 bis 5, umfassend:
Starten des Zerstäubens durch Einschalten der Hochfrequenz-Zerstäubungsenergiequelle (18), um Plasma zu erzeugen; und
Bilden einer piezoelektrischen Schicht durch Niederschlagen eines Targetmaterials auf dem Substrat in einem Zustand, in welchem ein Potential mit einer Potentiatdifferenz von 20 V oder darüber gegenüber Massepotential durch den Potentialeinstellmechanismus (100) an die mit dem Potentialeinstellmechanismus verbundene Anhaft-Verhinderungsplatte (23) angelegt wird,
**dadurch gekennzeichnet, dass** für den Fall, dass die Hochfrequenz-Zerstäubungsenergiequelle (18) abgeschaltet wird, nachdem die piezoelektrische Schicht eine vorbestimmte Dicke erreicht hat, eine Plasmadichte stufenweise verringert wird.

7. Verfahren zum Bilden einer piezoelektrischen nach Anspruch 6.
bei dem für den Fall, dass die Hochfrequenz-Zerstäubungsenergiequelle (18) abgeschaltet wird, die Plasmadichte dadurch stufenweise verringert wird, dass eine Ausgangsgröße der Hochfrequenz-Zerstäubungsenergiequelle (18) stufenweise verringert wird.

8. Verfahren zum Bilden einer piezoelektrischen Schicht nach Anspruch 6.
bei dem für den Fall, dass die Hochfrequenz-Zerstäubungsenergiequelle (18) abgeschaltet wird, die Plasmadichte stufenweise verringert wird durch pulsweises Treiben einer Ausgangsgröße der Hochfrequenz-Zerstäubungsenergiequelle (18) und stufenweises Verringern einer Pulsfrequenz.

9. Verfahren zum Bilden einer piezoelektrischen Schicht nach einem der Ansprüche 6 bis 8.
bei dem für den Fall, dass die Hochfrequenz-Zerstäubungsenergiequelle (18) abgeschaltet wird, die Plasmadichte stufenweise dadurch verringert wird, dass ein Potential der mit dem Potentialeinstellmechanismus verbundenen Anhaft-Verhinderungsplatte unter Verwendung des Potentialeinstellmechanismus (100) eingestellt wird, während die Plasmadichte stufenweise verringert wird.

## Revendications

1. Dispositif de formation de film (1, 2, 3, 4, 5) apte à former un film mince sur un substrat par pulvérisation cathodique d'une cible, le dispositif de formation de film comprenant :
une chambre de formation de film (15), laquelle est en mesure d'introduire ou d'évacuer un gaz de formation de film ;
une portion de maintien de cible (11) apte à maintenir la cible disposée dans la chambre de formation de film (15) ;
une portion de maintien de substrat (12), laquelle est disposée de manière à faire face à la portion de maintien de cible (11) dans la chambre de formation de film (15) et est apte à maintenir un substrat ;
une alimentation de pulvérisation cathodique radioélectrique (18) apte à générer un plasma dans un espace entre la portion de maintien de cible (11) et la portion de maintien de substrat (12),
dans lequel un mécanisme de prévention d'adhérence (20) est apte à empêcher l'adhérence d'un matériau cible à une surface de paroi interne de la chambre de formation de film (15), le matériau cible subissant une pulvérisation cathodique et une diffusion à partir de la cible dans la chambre de formation de film (15), dans lequel
le mécanisme de prévention d'adhérence (20) est configuré avec une pluralité de plaques de prévention d'adhérence incluant au moins une plaque de prévention d'adhérence de bord de substrat (23), laquelle est prévue sur un bord d'une région sur la portion de maintien de substrat (12), où le substrat est prévu, et une plaque de prévention d'adhérence de région périphérique extérieure de substrat (22), laquelle est disposée sur une périphérie extérieure de la plaque de prévention d'adhérence de bord de substrat (23) devant être espacée de la plaque de prévention d'adhérence de bord de substrat (23), et
un mécanisme d'ajustement de potentiel (100), lequel est connecté par voie électrique à l'un quelconque des éléments pami la plaque de prévention d'adhérence de bord de substrat (23) ou la plaque de prévention d'adhérence de région périphérique extérieure de substrat (22), et est apte à ajuster un potentiel de la plaque de prévention d'adhérence (23),
dans lequel
la plaque de prévention d'adhérence (23) connectée au mécanisme d'ajustement de potentiel (100) et une plaque de prévention d'adhérence adjacente à la plaque de prévention d'adhérence (23) connectée au mécanisme d'ajustement de potentiel (100) parmi la pluralité de plaques de prévention d'adhérence sont disposées suivant un intervalle allant de 0,5 mm à 3,0 mm, et
**caractérisé en ce que** l'alimentation de pulvérisation cathodique radioélectrique (18) et/ou le mécanisme d'ajustement de potentiel (100) sont configurés pour diminuer la densité de plasma de manière graduelle, dans un cas où l'alimentation de pulvérisation cathodique radioélectrique (18) est mise hors tension après que le film piézoélectrique a atteint une épaisseur prédéterminée.

2. Dispositif de formation de film (1, 2, 3, 4, 5) selon la revendication 1, comprenant en outre :
une portion de détection de décharge anormale (50) apte à détecter l'occurrence d'une décharge anormale dans la chambre de formation de film (15), et
un contrôleur de décharge anormale (52) apte à supprimer une décharge anormale dans un cas où l'occurrence de décharge anormale est détectée par la portion de détection de décharge anormale (50).

3. Dispositif de formation de film (1, 2, 3, 4, 5) selon la revendication 2,
dans lequel le contrôleur de décharge anormale (52) est apte à commander une impédance de plasma.

4. Dispositif de formation de film (1, 2, 3, 4, 5) selon la revendication 3, comprenant en outre :
une boîte d'adaptation d'impédance (54), laquelle est connectée à l'alimentation de pulvérisation cathodique radioélectrique (18),
dans lequel le contrôleur de décharge anormale (52) est apte à commander l'impédance de plasma en commandant la boîte d'adaptation d'impédance (54) de telle sorte qu'une fréquence de décharge soit ajustée.

5. Dispositif de formation de film (1, 2, 3, 4, 5) selon la revendication 3,
dans lequel le contrôleur de décharge anormale (52) est apte à commander l'impédance de plasma en commandant l'ajustement du potentiel à l'aide du mécanisme d'ajustement de potentiel (100).

6. Procédé destiné à former un film piézoélectrique à l'aide du dispositif de formation de film (1, 2, 3, 4, 5) selon l'une quelconque des revendications 1 à 5, comprenant les étapes consistant à :
lancer la pulvérisation cathodique en mettant sous tension l'alimentation de pulvérisation cathodique radioélectrique (18) afin de générer un plasma, et
former un film piézoélectrique en déposant un matériau cible sur le substrat dans un état où un potentiel présentant une différence de potentiel supérieure ou égale à 20 V par rapport au potentiel de terre est appliqué à la plaque de prévention d'adhérence (23) connectée au mécanisme d'ajustement de potentiel par le mécanisme d'ajustement de potentiel (100),
**caractérisé en ce que**
dans un cas où l'alimentation de pulvérisation cathodique radioélectrique (18) est mise hors tension après que le film piézoélectrique a atteint une épaisseur prédéterminée, une densité de plasma est diminuée graduellement.

7. Procédé destiné à former un film piézoélectrique selon la revendication 6,
dans lequel dans un cas où l'alimentation de pulvérisation cathodique radioélectrique (18) est mise hors tension, la densité de plasma est diminuée graduellement en diminuant une sortie de l'alimentation de pulvérisation cathodique radioélectrique (18) graduellement.

8. Procédé destiné à former un film piézoélectrique selon la revendication 6,
dans lequel dans un cas où l'alimentation de pulvérisation cathodique radioélectrique (18) est mise hors tension, la densité de plasma est diminuée graduellement en excitant par impulsions une sortie de l'alimentation de pulvérisation cathodique radioélectrique (18) et en diminuant une fréquence d'impulsion graduellement.

9. Procédé destiné à former un film piézoélectrique selon l'une quelconque des revendications 6 à 8,
dans lequel dans un cas où l'alimentation de pulvérisation cathodique radioélectrique (18) est mise hors tension, la densité de plasma est diminuée graduellement en ajustant un potentiel de la plaque de prévention d'adhérence (23) connectée au mécanisme d'ajustement de potentiel à l'aide du mécanisme d'ajustement de potentiel (100) tout en diminuant la densité de plasma graduellement.
